Europäisches Patentamt

European Patent Office

Office européen des brevets

(19)

(11) EP 0 517 503 B1

(12) EUROPEAN PATENT SPECIFICATION

(45) Date of publication and mention
of the grant of the patent:
13.08.1997 Bulletin 1997/33

(51) Int Cl.⁶: **H01S 3/06**, H01S 3/131,
H01S 3/133

(21) Application number: 92305084.3

(22) Date of filing: 03.06.1992

(54) **Optical amplifier**

Optischer Verstärker

Amplificateur optique

(84) Designated Contracting States:
**DE FR GB**

(30) Priority: **03.06.1991 JP 131326/91**

(43) Date of publication of application:
**09.12.1992 Bulletin 1992/50**

(73) Proprietor: **NIPPON TELEGRAPH AND
TELEPHONE CORPORATION
Shinjuku-ku, Tokyo 163-19 (JP)**

(72) Inventors:
• **Aida, Kazuo
Yokohama-shi, Kanagawa 236 (JP)**
• **Masuda, Hiroji
Yokosuka-shi, Kanagawa 238 (JP)**
• **Nakagawa, Kiyoshi
Miuragun, Kanagawa 240-01 (JP)**

(74) Representative: **Darby, David Thomas et al
Abel & Imray
Northumberland House
303-306 High Holborn
London WC1V 7LH (GB)**

(56) References cited:
EP-A- 0 395 277        GB-A- 2 244 595
US-A- 5 018 152

• **PATENT ABSTRACTS OF JAPAN vol. 10, no. 376
(E-464)13 December 1986 & JP-A-61 168 282**
• **PATENT ABSTRACTS OF JAPAN vol. 15, no. 036
(E-1027)29 January 1991 & JP-A-02 273 976**
• **TRANSACTIONS OF THE INSTITUTE OF
ELECTRONICS, INFORMATION AND
COMMUNICATION ENGINEERS. B - I vol. J 75 B-I,
no. 5 , May 1992 , JP pages 298 - 303 K. AIDA ET
AL. 'Automatic gain control of erbium-doped
fiber amplifier by detecting spontaneous
emission power along the fiber'**

**Description**

The invention relates to an optical amplifier for use in an optical transmission system or in an optical signal processing system.

Laser diodes and optical fibres doped with a rare-earth element have both been used as optical amplifiers. All known optical amplifiers include arrangements for reducing the gain in proportion to increasing optical power and are prone to linearity problems when attempts are made to increase the operating signal level. The use of a feedback system has been proposed as a means of overcoming these problems. In the use of the proposed feedback system in an optical amplifier, the feedback system controls the supply energy to the amplifier in accordance with the input and output signal levels and maintains a constant gain. The supply energy is a driving current in the case of a laser diode amplifier and is a light source in the case of a doped optical fibre.

Conventional optical amplifiers suffer from a decrease in their output level and a reduction in S/N ratio when a feedback system is used for reasons which include the following:

(1) a part of the signal light is lost in the couplers provided at the input and the output sections,
(2) the number of connections with the couplers increases, and
(3) excessive loss is caused in the couplers.

Moreover, the optical system and the circuit for control system become complicated. They are also defective in that as the input light is comparea with the output light, it cannot control the system when there is no optical signal. More particularly, because the input optical signals are conveying information, there are unavoidably times that signals become zero in the intensity modulation systems, and the time constant of the control system must be carefully determined with due consideration to statistical characteristics of the input optical signals. Further, as the output light includes spontaneous emission which has been amplified, control error inevitably increases in the amplifier with larger gains.

The present invention aims to solve these problems encountered in the prior art and to provide a simply structured optical amplifier which can maintain gains constant without the need to detect input or output light.

European Patent Application No. 0 395 277 discloses an optical amplifier with automatic gain control including an input port for receiving an optical signal for amplification, means for achieving amplification of the optical signal, means for extracting a portion of the amplified signal and an output port providing the remainder of the amplified optical signal, wherein feedback loop means employs the extracted portion of the amplified signal to maintain the output optical signal at a constant level and the extracted portion comprises spontaneous emission at a control wavelength or band of wavelengths different from the wavelength or band of wavelengths of the output amplified optical signal.

The invention provides an optical amplifier comprising a rare-earth doped optical fibre, a pump light source for pumping light into the optical fibre to excite the rare-earth dopant which, in operation, amplifies an optical signal incident on the optical fibre, wherein the optical amplifier includes a detecting means for detecting spontaneous emission from the sides of the optical fibre and a feedback means for so controlling the pump light source that, in operation, the detected level of the spontaneous emission is maintained substantially constant.

In one embodiment the detecting means includes a photodetector and the photodetector is placed within an integrating sphere that surrounds the optical fibre.

In another embodiment the optical fibre forms a coil and the detecting means includes a photodetector positioned by the side of the coil.

In a further embodiment the optical fibre includes a series of loops forming a curved structure having convex and concave faces and the detecting means includes a photodetector positioned to receive light from the concave face of the curved structure.

In one arrangement the detecting means includes a plurality of photodetectors positioned along the optical fibre, the feedback means including a processing means for processing the detected values obtained from the plurality of photodetectors and controlling the pump light source in accordance with the processed values.

Preferably, the optical amplifier includes an optical bandpass filter, the detecting means including a photodetector and the optical bandpass filter being positioned between the photodetector and the optical fibre for selecting light close to the signal-light wavelength for transmission to the photodetector.

The optical amplifier may include a mirror so positioned that the optical fibre lies between the mirror and the detecting means.

The optical amplifier may include an optical system positioned between the detecting means and the optical fibre, the optical system being capable of compensating for variations in the sensitivity of the detecting means according to the angle at which light falls on the detecting means.

The optical amplifier may include a second detecting means for detecting the optical power output from the optical fibre at the signal-wavelength, an integrating means for integrating the detected optical power over a period longer than a time constant $T_s$ based on the statistical characteristics of the signal and a control means for so controlling a reference gain of the doped optical fibre in accordance with the output value from the integrating means as to cause the average optical power output from the optical fibre to remain substantially constant.

One arrangement of the optical amplifier includes a first computing means for receiving information from the feedback means regarding the power supplied by the pump light source and calculating the optical power output from the optical fibre in accordance with the relationship between a previous pump light power and the corresponding gain of the optical fibre, a second computing means for integrating the calculated value of the optical power output over a period longer than a time constant $T_s$ based on the statistical characteristics of the signals in order to obtain an average value of the optical power output and a control means for so controlling the feedback means as to make the average value of the optical power output equal to a selected reference value.

Another arrangement of the optical amplifier includes a control unit connected to control the pump light source, the control unit including an input port for receiving the output from the detecting means, input ports for receiving setting values for gain and wavelength for the optical fibre and an output port for providing an alarm signal when the control unit so controls the pump light source as to demand output power at a level that exceeds an operational limit that is determined by the set values for gain and wavelength.

Preferably, the optical amplifier includes a temperature sensor positioned to sense the temperature of the optical fibre, the temperature sensor being connected to a compensating means for so varying the power delivered by the pump light source as to compensate for temperature-dependent changes in the spontaneous emissions from the optical fibre.

An arrangement of the optical amplifier includes an additional pump light source for pumping light into the optical fibre connected to an additional detecting means for detecting spontaneous emissions from the sides of the optical fibre and an additional feedback means for controlling the output power from the additional pump light source, the gains of the feedback means being set to differ from each other.

Preferably, the optical amplifier includes a monitor-and-control unit for monitoring the operation of each of the feedback means, setting the gain of each of the feedback means and switching off any faulty feedback means.

Preferably, the feedback means include drive circuits for offsetting differences in characteristics between the pump light sources.

Preferably, each pump light source is an integral part of a pump module that includes a drive circuit for the pump light source.

Preferably, the pump modules are capable of being switched on and off and means are included for switching the pump modules on and off, the optical amplifier including low-pass electrical filters for the feedback means that control the respective pump modules and a comparator means for inserting the low-pass electrical filters into the respective feedback means for a predetermined period that starts when the respective pump modules are switched on, the low-pass electrical filters having narrower passbands than the respective feedback means.

The optical amplifier may be connected in cascade with a similar amplifier, the gain of the first amplifier in the cascade being greater than that of the second amplifier in the cascade.

The optical amplifier may be connected in cascade with a plurality of similar amplifiers, there being included a multiple-control monitor-and-control unit for so varying the gain distribution among the amplifiers as to maintain a constant gain for the cascade of amplifiers.

Optical amplifier arrangements in accordance with the invention will now be described by way of example only with reference to the accompanying drawings, in which:

Figs. 1 to 11 show the construction of several different forms of optical amplifier in accordance with the invention,
Fig. 12 shows a feedback arrangement similar to one included in Fig. 1 used with a laser diode amplifier which is not in accordance with the invention,
Figs. 13 to 18 show further forms of the optical amplifier in accordance with the invention,
Fig. 19 is a graphical representation of the relationship between the output signal level and the optical pumping power for forms of the optical amplifier shown in Figs. 1 to 11 and 13 to 18,
Fig. 20 shows an experimental structure for assessing the performance of an optical amplifier in accordance with the invention,
Fig. 21 shows an enlarged side view of the essential parts of the experimental structure shown in Fig. 20,
Fig. 22 is a graphical representation of the relationship between the gain and the integrated value of the spontaneous emission for forms of the optical amplifier as shown in Figs. 1 to 11 and 13 to 18,
Fig. 23 is a graphical representation of the relationship between the integrated value of the spontaneous emission and the input signal level along with the relationship between the optical pumping power and the input signal level for forms of the optical amplifier as shown in Figs. 1 to 11 and 13 to 18,
Fig. 24 is a graphical representation of the relationship between the gain and the input signal level for forms of the optical amplifier as shown in Figs.1 to 11 and 13 to 18 and
Figs. 25 and 26 show further embodiments of the invention.

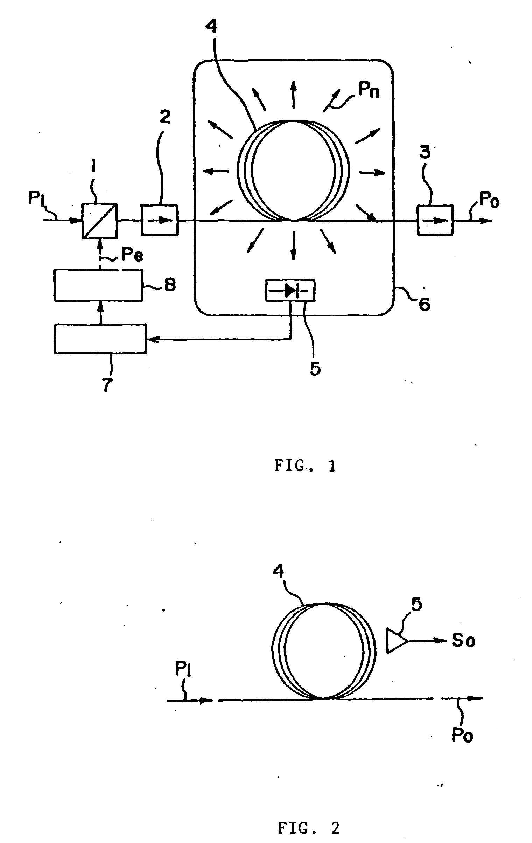

FIG. 1 shows the first embodiment of the optical amplifier according to this invention wherein the reference numeral 1 denotes a WDM (wavelength division multiplexing) coupler, 2 and 3 denotes isolators, 4 denotes rare - earth doped optical fibers, 5 denotes a photodetector, 6 denotes an integrating sphere, 7 denotes a drive circuit, and 8 denotes a pump light source. The rare - earth doped optical fiber 4 which is doped with rare - earth atoms (or ions) such as erbium is provided within a known integrating sphere 6 together with a photodetector 5. One end of the rare - earth doped optical fiber 4 is connected a WDM coupler 1 and an isolator 2 to incident an input light Pi as well as the pump light Pe source 8 while the other end thereof is connected an isolator 3 to take out an output light Po. The optical amplifier is structured in a manner that the integrated value of the spontaneous emission Pn from the side of the rare - earth doped optical fiber 4 is detected by the photodetector 5 and the pump light source 8 is controlled by the drive circuit 7 to make the detected values become constant.

The gain G of the rare-earth doped optical fiber amplifier is expressed as below.

$$G = \exp \left( \int_0^L \gamma (z) \, dz \right) \tag{1}$$

wherein the letters $\gamma (z)$ denote a local gain of the rare-earth doped optical fiber 4, the letter L denotes the length of the rare-earth doped optical fiber 4, and the local gain $\gamma (z)$ of said fibers 4 is a function of the position on the fiber, the strength of the pump light and the intensity of the signal light.

Said local gain $\gamma (z)$ may be expressed with the spontaneous emission Pn (z) on the sides of the fiber and other constants as below.

$$\gamma (z) = C \cdot Pn (z) - \alpha_s \tag{2}$$

wherein

$$C = [\eta \, \{\sigma_{emi}(\lambda_s) + \sigma_{abs}(\lambda_s)\} \, \tau]/(h \cdot \nu_n \cdot \pi \cdot \Gamma_{Er}^2)$$

$$\alpha_s = \eta \cdot \sigma_{abs}(\lambda_s) \cdot \rho$$

| | |
|---|---|
| $\sigma_{abs}(\lambda_s)$ : | absorption cross-section at signal wavelength |
| $\sigma_{emi} (\lambda_s)$ : | stimulated emission cross-section at signal wavelength |
| $\eta$ : | overlap factor |
| $\tau$ : | life time of spontaneous emission |
| $\rho$ : | doping level of erbium (Er) |
| h : | Planck's constant |
| n : | avarage frequency of spontaneous emission |
| $\Gamma_{Er}$ : | radius of the area doped with Er |

The letters $\alpha_s$ (absorption loss of the rare-earth doped fibers due to a faint signal light) and C are the constants which are not dependent on the position on the fiber, the strength of the pump light and the intensity of the signal light.

From the equations (1) and (2), the gain G may be represented by the equation below.

$$G = \exp \left( \int_0^L Pn (z) \, dz - \alpha_s \cdot L \right) \tag{3}$$

In other words, by controlling the integrated value of the spontaneous emission Pn (z) from the side of the rare-earth doped optical fiber along the length of the fiber to be a given value, the gain G can be maintained at a constant level because C and $\alpha_s \cdot L$ are constants.

The first embodiment of this invention shown in FIG. 1 is structured in a manner that the rare-earth doped optical fiber 4 and the photodetector 5 are arranged inside the integrating sphere 6 to detect the integrated value of the spontaneous emission from the side of said rare-earth doped optical fiber 4 and the pump light source 8 is controlled by the drive circuit 7 to make the detected value become constant to thereby keep the gain G constant. If plural photodetectors are used, the precision of detecting integrated value could be improved. If plural pump light sources are used, even when a part of the light sources fails, the gain G could be kept at a constant level by the remaining light sources without suspending any signal even for an instant to thereby improve the reliability greatly.

As stated in the foregoing, by arranging rare - earth doped optical fiber and at least one photodetector within an integrating sphere, detecting the integrated value of the spontaneous emission from the side faces of said rare - earth doped optical fiber, and controlling at least one pump light source to maintain the detected value at a constant level so that the gain can be controlled to be constant without the need to detect the signal light and that changes in the gain which otherwise may be caused due to the signal mark density variation can be perfectly inhibited.

FIG. 2 shows the second embodiment of the optical amplifier according to this invention wherein rare - earth doped optical fiber 4 is wound in a coil, a photodetector 5 is arranged by the side thereof to detect the spontaneous emission from the side of the rare - earth doped optical fiber, and a pump light source (not shown) is controlled to make the detected value become constant.

With this structure, when the diameter of the coil of the optical fiber 4 is set at R, the spontaneous emission from the side thereof may be sampled at an interval of $\pi.R$ to detect the sum thereof by one photodetector. The sum is an approximate value of the integrated value of the spontaneous emission from the side of the optical fiber. As the amplifier is structured to control the pump light source to make the detected value So become constant so that the gain G would be maintained at a constant level. If plural pump light sources are used, even if a part of the light sources fails, the gain G would be controlled to be constant by the remaining light sources to prevent suspension of the signals even for an instant. This could greatly enhance the reliability.

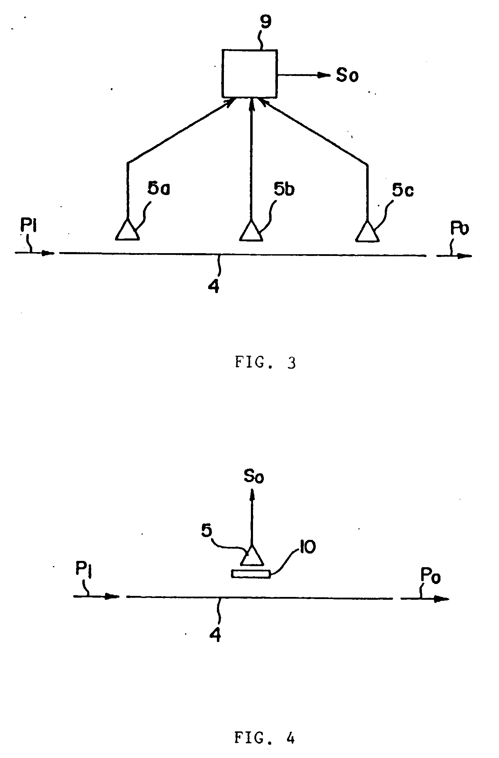

FIG. 3 shows the third embodiment of this invention wherein plural photodetectors 5a, 5b, and 5c are placed at different positions along the side of the rare-earth doped optical fiber 4 to detect the distance distribution characteristics of the spontaneous emission from the side of the optical fiber 4, detected value being processed by a computing unit (CPU) 9 for a predetermined operation and the pump light source (not shown) is controlled to make the result of the operation So become constant.

With this structure, an approximate So of the integrated value of the spontaneous emission from the side of the fiber may be obtained by multiplying the detected values obtained from the plural photodetectors 5a, 5b, and 5c with a weight coefficient and adding them to get the sum, based on the theory of numerical integration, and further the gain G may be kept constant by controlling the pump light sources in a manner to make the approximate So to be constant. As the local gain distribution in the longitudinal direction of the fiber is measured in this optical amplifier, the length characteristic G (z) of the gain may be known. Moreover, the noise figure NF which is as an important factor as gain may be known. More particularly, the noise figure NF may be expressed as below.

$$NF = \{2/ (1 + \sigma^a_s/\sigma^e_s)\} \cdot [\{\alpha_s G (L) / (G (L) - 1)\}$$

$$\cdot \int_0^L (1/G (z)) \, dz + 1] \tag{4}$$

wherein

$\sigma^a_s$:    absorption cross-section at signal wavelength
$\sigma^e_s$:    stimulated emission cross-section at signal wavelength

A two-way pumping method is used for excitation. The gain may be controlled with a higher precision than in the case of the one-way pumping method (forward or backward pumping) by controlling the pump light source based on the equations (3) and (4), and minimizing the changes in noise figure NF against the changes in input signal level. Similarly to the optical amplifiers shown in Figures 1 and 2, if plural pump light sources are used, the gain G may be controlled constant even if a part of the light sources fails, by the remaining light sources to prevent suspension of the signals even for an instant to greatly enhance the reliability.

FIG. 4 shows the fourth embodiment of this invention wherein a optical band pass filter 10 is placed between the rare-earth doped optical fiber 4 and the photodetector 5 which transmits the optical band including and closing to that of the signal light. This structure can remove lights of wavelengths other than those used in operation to thereby control the gain more precisely.

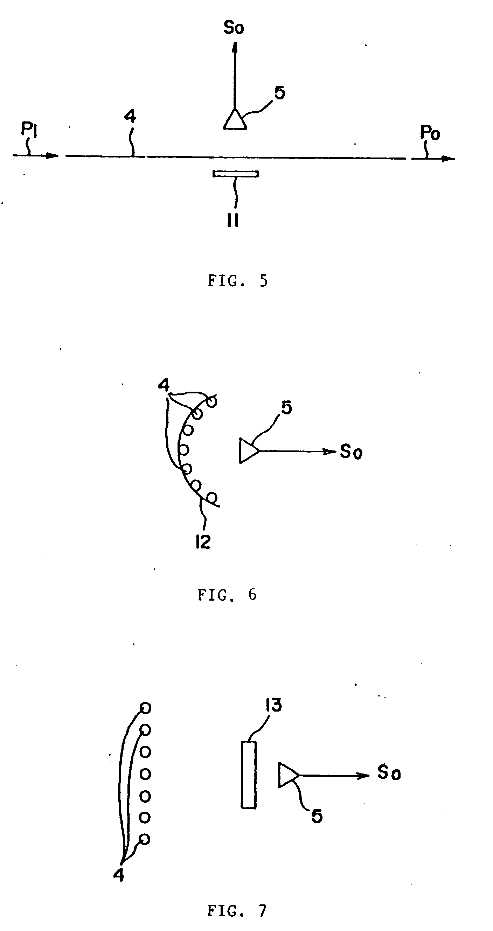

FIG. 5 shows the fifth embodiment of this invention. This embodiment is structured to have a mirror 11 at a position opposing the photodetector 5 across the rare-earth doped optical fiber 4. This increases spontaneous emission incident to the photodetector 5 to thereby increase the S/N ratio in the control system.

FIG. 6 shows the sixth embodiment of this invention wherein rare-earth doped optical fiber 4 is provided on the predetermined circumference 12 around a photodetector 5. This permits even detection of the spontaneous emission from respective parts of the fiber to thereby increase the detection precision of the integrated value of the spontaneous emission.

FIG. 7 shows the seventh embodiment of this invention wherein a space filter or an optical system 13 is provided in front of a photodetector 5 to compensate the incident-angle dependency of the detection sensitivity. The optical system 13 may be a lens or a prism. This structure allows even detection of the spontaneous emission from each part of the fiber to thereby increase the detection precision of the integrated value of the spontaneous emission.

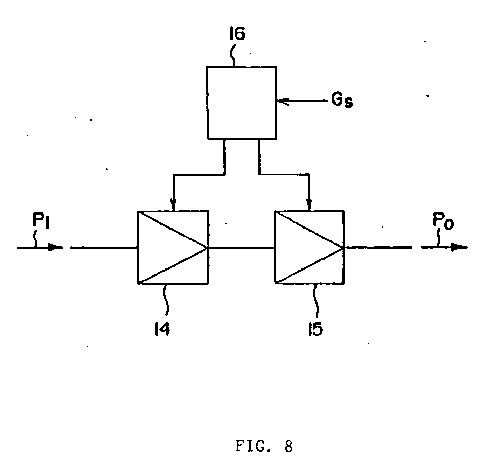

FIG. 8 shows the eighth embodiment of the invention. FIG. 8 shows two optical amplifiers 14 and 15 connected in cascade and a control unit 16 connected to the two amplifiers 14 and 15. The overall reference or target gain is $G_s$ and the control unit 16 produces respective gains $G_{14}$ and $G_{15}$, respectively, for the amplifiers 14 and 15 satisfying the relationship $G_{15} = G_s/G_{14}$. The optical amplifier 14 to which is applied a light input $P_i$ is set to a higher gain than the amplifier 15 from which the light output $P_o$ is obtained. The lower gain may be less than unity. This arrangement may control the gain of the optical amplifier which follows and not suffer an increase in the net noise figure as would normally be the case when the gain of the preceding amplifier is reduced. Therefore, the gain of the whole system may be varied quite significantly.

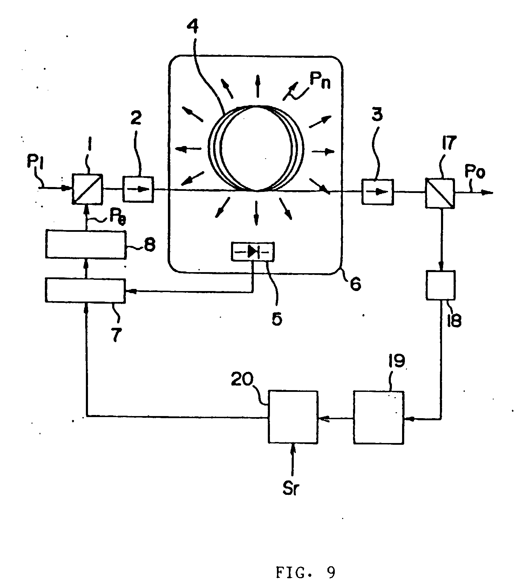

FIG. 9 shows the ninth embodiment of the invention. FIG. 9 shows the light output $P_o$ from an optical amplifier 6 taken via an isolator 3 to a distributor 17 from which it passes to a photodetector 18 which detects the output signal power. An integrator 19 then integrates the detected power over a time period longer than a time constant $\tau_s$(the time when the value no longer changes) which is based on the statistical characteristics of the input signals, the integrated value is compared by a comparator 20 with the reference value Sr of the output signal level, and the pump light source 8 is controlled by a drive circuit 7 to make the average output signal power become constant by using the result of the comparison.

Before going into the explanation of the merits of this optical amplifier, the background will be described. The input signal power an optical amplifier used in the optical repeater/transmitter system varies according to the changes in the loss (temperature characteristics, chronological change characteristics) in the optical fiber transmission line. The smaller becomes the fiber loss, the larger becomes the power of input signals, but if the gain of the optical amplifier is kept constant, the output signal power will sometimes exceed the input limit (due to the nonlinear effect) of the optical fiber. As the fiber loss increases, the input signal power decreases, but if the gain of the optical amplifier is kept constant, the output signal power also decreases to deteriorate the S/N ratio of the transmission system. Therefore, the output signal power of the optical amplifier should be maintained at the reference value (a constant value).

A limiter amplifier may satisfy the above requirement, but as the linearity of input/output cannot be maintained when a light amplitude modulation system is used, it would increase the distortion factor in the analog transmission system and deteriorate the error rate in the digital transmission system. Moreover, the optical repeater/transmitter system generally requires the output signal power as high as + 10 dBm for the optical amplifier, but this value is within the saturation region of the optical amplifier and unless the gain is controlled to be constant, the transmission characteristics would deteriorate. In short, optical amplifiers used in the optical transmission system must be simultaneously solved these apparently contradictory two problems (i.e. constant output and constant gain).

The optical amplifier shown in FIG. 9 can control the reference gain of the optical amplifier with the integrated value of the optical power of the output signals light to make the average power of the output signals become constant, and control the pump light source by the time sufficiently shorter than the spontaneous emission life time $\tau$ of the rare-earth doped optical fiber using the reference gain and the integrated spontaneous emission, thereby causing the gain to coincide with the reference gain. As a result, the linearity of the input/output of the amplifier is maintained to prevent deterioration in transmission characteristics. Further, as the output level is kept constant (the averaging time is longer than the time constant $\tau_s$), the transmission characteristics would not deteriorate by the input limit of the optical fiber and the S/N ratio would not deteriorate.

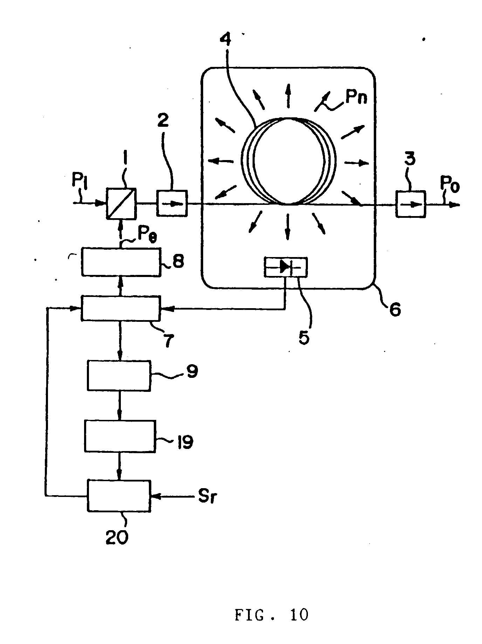

FIG. 10 shows the tenth embodiment of this invention wherein operation information of the pump light power is extracted from the drive circuit 7, the output signal level (optical power of the signal light) is calculated by the computing unit 9 based on the relation of the information with the reference gain of the optical amplifier, the average output signal power is calculated by integrating the level by an integrator 19 with a time longer than the time constant $\tau_s$ based on the statistical characteristics of the signals, the average output signal power and the reference value Sr of the output signal level are compared with a comparator 20, and the pump light source 8 is controlled by the drive circuit 7 to make the average output signal power constant according to the result of calculation.

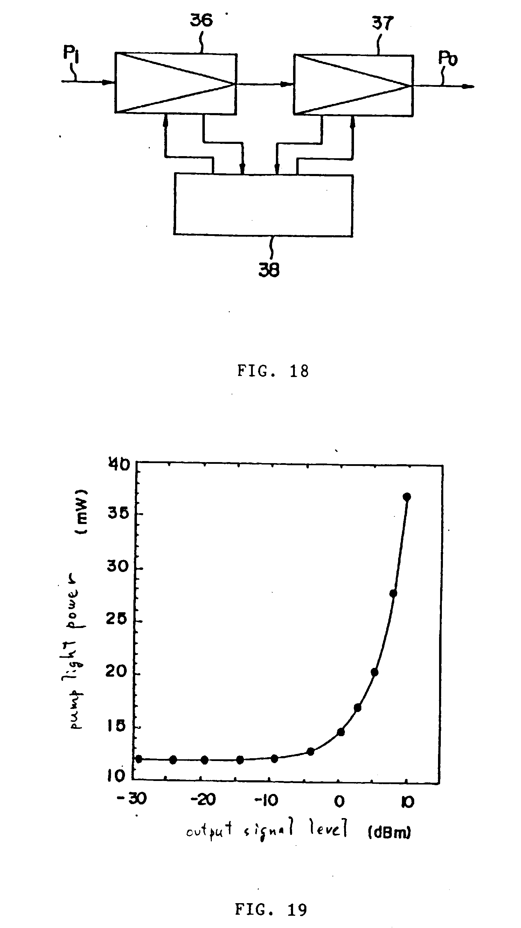

The graph in FIG. 19 shows an example of the relation between the output signal level and the pump light power when the gain is controlled constant at 20 dB. In the region where the output signal level exceeds 0 dBm, when the pump light power is set at a level, the signal output level will be automatically determined. This fact is used by the embodiment shown in FIG. 10 while the gain is made coincident with the reference gain by not only controlling the average output signal power constant, but also controlling the pump light sources based on the reference gain and integrated spontaneous emission with the time sufficiently shorter than the metastable-level lifetime $\tau$ of the rare-earth doped optical fiber. As a result, the linearity of the input/output of the amplifier is maintained not to cause deterioration of transmission characteristics. Moreover, the output level is also maintained at a constant level (the average value by a longer time than the time constant $\tau_s$ is maintained constant), it becomes possible to avoid the deterioration in transmission characteristics or of the S/N ratio which otherwise would be caused due to the input limit. According to this embodiment, as it is not necessary to provide a coupler at an output in order to divide the output signals and to detect the power thereof, the structure becomes simple and the loss otherwise caused by coupling will be avoided, and a higher output becomes possible.

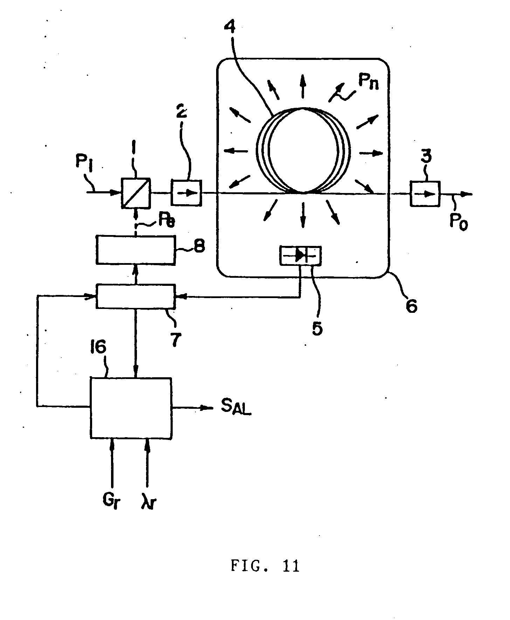

FIG. 11 shows the eleventh embodiment of the optical amplifier according to this invention wherein a control unit 16 is inputted a gain Gr and a wavelength $\lambda_r$ for the gain Gr from outside and compares the gain Gr with a gain obtained by converting the integrated value of the spontaneous emission, the pump light source 8 is controlled by the drive circuit 7 based on the result of the comparison, and when the control amount (drive current) to the pump light source 8 exceeds the operational limit, an alarm $S_{AL}$ is generated.

In other words, a gain Gr and a wavelength $\lambda r$ to obtain such gain Gr is inputted from outside to the control unit 16. The control unit 16 calculates an integration value of the spontaneous emission corresponding to the gain by said equation (3) and transmits a reference value of the spontaneous emission to the drive circuit 7. The drive circuit 7 compares the reference value with the detected integrated value of the spontaneous emission to control the light source 8 and transmits an information relating to the driving current for the light source 8 to the control unit 16. As a result, the control unit 16 becomes capable of generating an alarm $S_{AL}$ when the set gain or input signal level is too high and the control amount (drive current) for the pump light source 8 exceeds the operating limit. Therefore, it becomes possible to check whether or not the optical amplifier is normally operating.

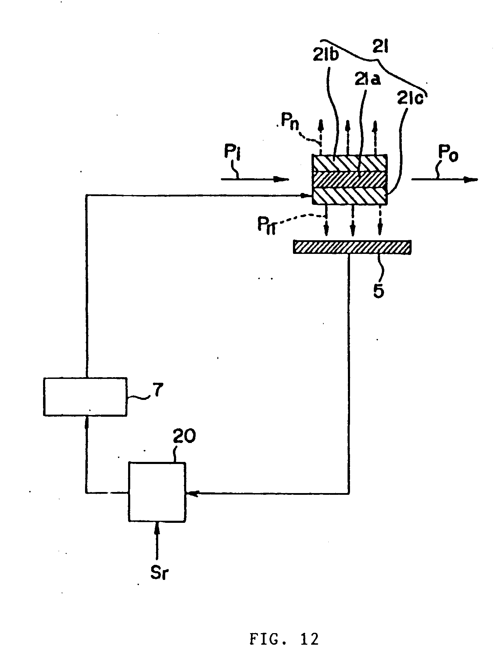

FIG. 12 shows the twelfth embodiment of the optical amplifier according to this invention wherein a photodetector 5 is placed at the side of a laser diode amplifier 21 which comprises an active layer 21a and electrodes 21b and 21c and which is pumped by electric current. The total amount of the spontaneous emission from the sides of the amplifier 21 or a proportional value Pn of the total amount is detected, the detected value is compared to the reference value Sr by a comparator 20, and the drive circuit 7 controls the driving current to become the detected value constant.

Similarly to the case of a rare-earth doped optical fiber amplifier, the gain G of a laser diode amplifier is expressed by the following equation.

$$G = \exp \left( C \int_0^L Pn\ (z)dz - \alpha_s \cdot L \right) \qquad (3)$$

In other words, as C and $\alpha_s \cdot L$ are constants, the gain G may be maintained at a constant level by controlling for the value obtained by integrating the spontaneous emission Pn (z) from the sides of the laser diode amplifier along the length of the active layer to become a constant value. $\alpha_s$ and C are constants which are not dependent on the position of the active layer, the pumping strength and the signal power intensity, and respectively expressed as below.

$$C = \Gamma\alpha \cdot A \cdot \tau / (v \cdot h \cdot v_n \cdot S)$$

$$\alpha_s = \Gamma\alpha \cdot A \cdot n0,\ \alpha/v$$

wherein

| | |
|---|---|
| $\alpha_s$ : | absorption loss of the active layer for small level signal light |
| h : | Planck's constant |
| $\Gamma\alpha$ : | confinement coefficient ($\alpha$ denotes polarization mode (TE or TM) |
| A : | differentiated gain coefficient |
| $\tau$ : | carrier life time |
| v : | light velocity through medium |
| $v_n$: | average frequency of spontaneous emission |
| S : | cross-section of the active layer |
| n0, $\alpha$ : | carrier density where gain is produced |

As the spontaneous emission from the sides of the laser diode amplifier is not uniform in this embodiment, it is desirable to obtain the total amount by integrating all the emission along the entire length of the active layer, but for practical purposes, it would suffice if a proportional value of the total is measured. By controlling for the value to become constant, the gain G may be maintained constant because C and $\alpha_s \cdot L$ are constants.

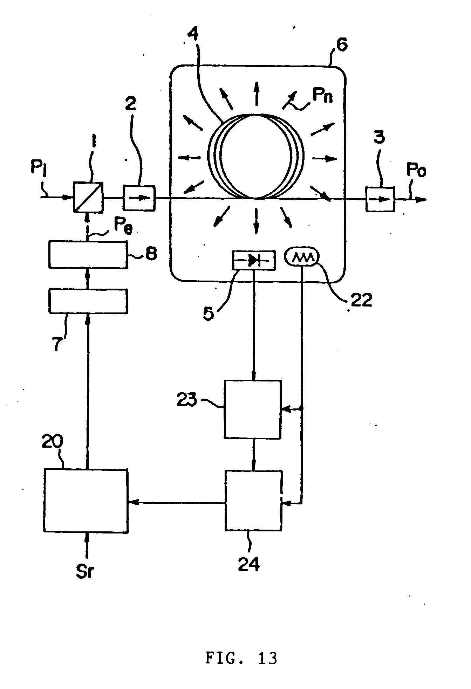

FIG. 13 shows the thirteenth embodiment of the optical amplifier according to this invention wherein a temperature sensor 22 is placed in the neighborhood of the rare-earth doped optical fibers 4 to detect the operational temperature thereof. The temperature characteristics of the spontaneous emission Pn detected by the photodetector 5 and the temperature characteristics of the loss in the signal light wavelength of the fiber 4 are compensated by a temperature characteristic compensating circuit 23, the gain is calculated from thus compensated value from a gain computing circuit 24, the obtained value is compared with the reference value Sr by a comparator 20, and the pump light source 8 is controlled by the drive circuit 7 to make the gain become constant. Although spontaneous emission is dependent on temperature, this embodiment has a means to compensate it. The fiber loss in the signal light wavelength is also dependent on temperature, but it becomes also compensable. As a result, when the gain of the optical amplifier is calculated from the spontaneous emission, the errors otherwise caused due to temperature characteristics may be avoided to thereby control the gain to be constant.

Similarly to this embodiment, a temperature sensor may be placed in the neighborhood of the laser diode amplifier in the embodiment shown in FIG. 12 to compensate the temperature characteristics of the spontaneous emission or of the signal light wavelength, especially the temperature characteristics of the signal light wavelength in the active layer thereof based on the operating temperatures detected by the sensor.

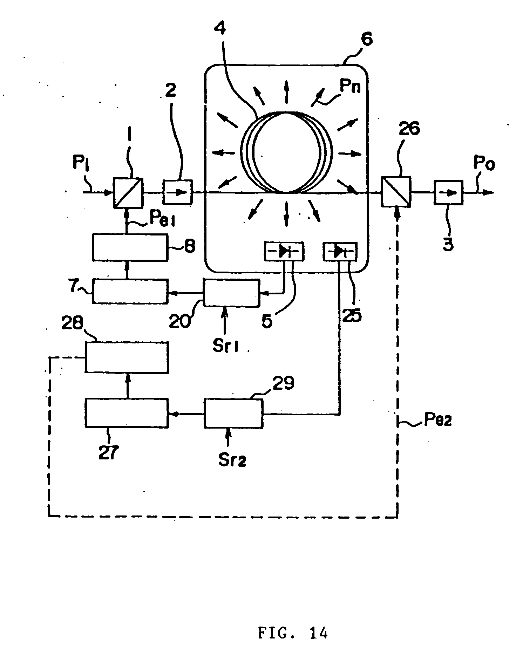

FIG. 14 shows the fourteenth embodiment of this invention wherein plural pump light sources 8, 28 are provided and photodetectors 5, 25 within an integrating sphere 6 and plural feedback loops are arranged corresponding to each of the light sources. A coupler 26 is inserted between an end of the rare-earth doped optical fiber 4 and the isolator 3. In the first feedback loop, the detected value of the spontaneous emission Pn from the side of the optical fiber 4 from the photodetector 5 are compared with the reference value Sr1 by a comparator 20, and the pump light Pe1 from the light sources 8 is controlled by the drive circuit 7 based on the result of the comparison. In the second loop, the detected value from the photodetector 25 is compared with the reference value Sr2 by the comparator 29 and the pump light Pe2 from the light source 28 is controlled by the drive circuit 27. Because the gains by the two feedback loops or the reference values Sr1 and Sr2 at the two comparators 20, 29 are slightly different from each other, the loop which is set with the largest gain is to be operated and the pump light source (s) at the other loop (s) is (are) controlled to be minimum operation state (which is determined by the circuit design). Therefore, the pump light source (s) of the other loop (s) is (are) kept hot standby in respect of operation, but kept at cold standby in respect of reliability. It means when the predetermined gain cannot be obtained due to some failure of the pump light source or in the control system in the active feedback loop, and the gain decreases to a level lower than the gain at the second feedback loop set with the second largest gain, then the second feedback loop will start operation and the gain would not decrease further.

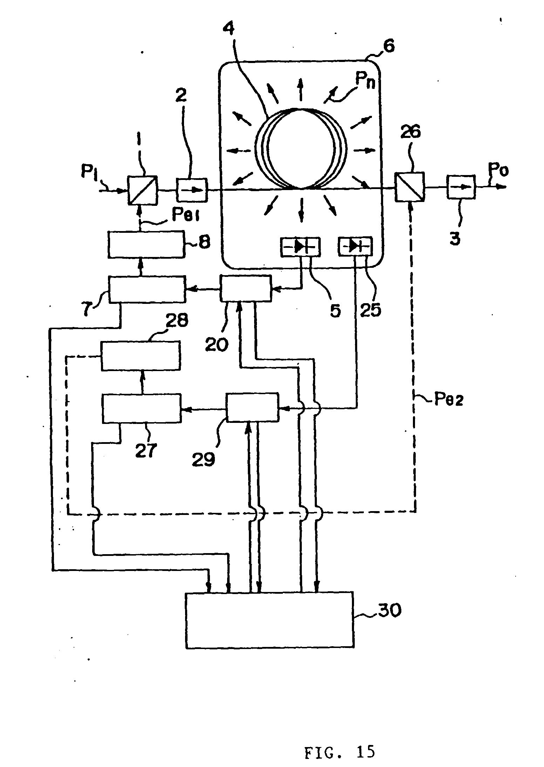

FIG. 15 shows the fifteenth embodiment of this invention wherein a monitor and control unit 30 monitors operations of the drive circuits 7 and 27 and the comparators 20, 29 as well as controls the reference gain setting at each comparator 20 or 29 and the switching thereof.

In this embodiment, in addition to the structure of the optical amplifier shown in FIG. 14, a monitor and control unit 30 is provided to monitor the operations of the plural feedback loops and controls the reference gain setting and switching thereof. If a failure takes place in the first feedback loop and its gain increases, the monitor and control unit 30 switches the failed first loop off. The gain of the optical amplifier then lowers to the level below the gain set at the second feedback loop, the second loop automatically starts operation to prevent the gain from further lowering. Therefore, even if the signal level slightly decreases, the signal light can be amplified without even an instantaneous break. Moreover, the amplifier may be restored to the original state by re-setting the gain of the second feedback loop at the same value as the first feedback loop by the monitor and control unit 30.

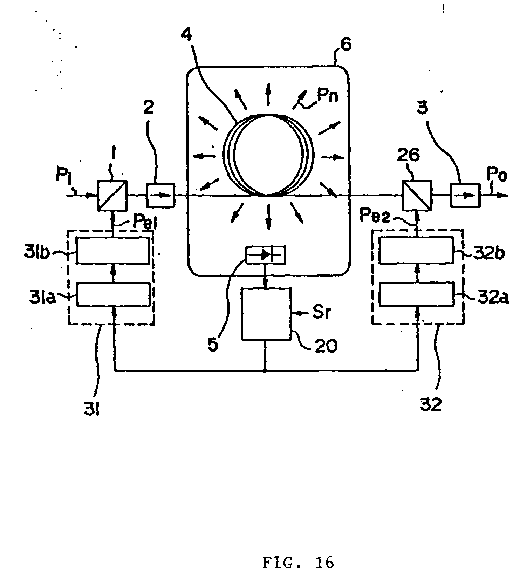

FIG. 16 shows the sixteenth embodiment of this invention wherein a pump module 31 which integrates the drive circuit 31a and the pump light source 31b having a circuit for offsetting the difference in characteristics between the light sources so as to make the characteristics of all the pump light sources identical when viewed from the comparator 20, and a pump module 32 source 32b are connected to the comparator 20 in parallel. level from respective pump modules to thereby enhance the the gain is controlled to be constant by the other pump module, and therefore signals are prevented from being suspended even for an instant to thereby enhance the reliability of the optical amplifier.

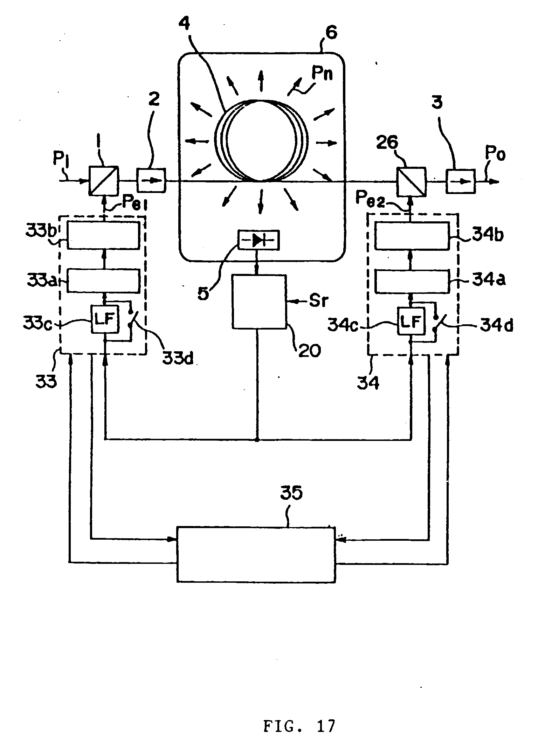

FIG. 17 shows the seventeenth embodiment of this invention. In this embodiment, two pump modules 33 and 34 are connected in parallel to a comparator 35. One of the pump modules 33 integrally comprises a drive circuit 33a having a circuit to offset the difference of pump light sources in characteristics thereof in a manner to make the characteristics of all the pump light sources identical to each other when viewed from the comparator 20, a pump light source 33b, a low-pass filter 33c having the band narrower than the control band of the comparator 20, and its by-pass switch 33d while the other pump module 34 integrally comprises a similar drive circuit 34b, a pump light source 34b, a low-pass filter 34c and a by-pass switch 34d. The control unit 35 inserts a low pass filter within the control loop in the initial stage where both of the pump modules 33 and 34 are switched from OFF to ON, and separates the low pass filter from the loop by turning the by-pass switch ON after a predetermined time period.

The operation of this optical amplifier will now be described. In the initial state, the gain is controlled to be constant by the first pump module 33 and the second pump module 34 in OFF state is connected to an output of the feed back loop thereof. Under such a state, the second pump module 34 is switched from OFF to ON. If no low-pass filter 34c is provided, the control signal would abruptly be applied to the light source 34d in step form, and the output pump light from the second pump module 34 would include the frequency components higher than the control band of the feedback loop. Moreover, it may include a transient response component in spike, which temporarily incapacitates the control of the gain at a constant level.

However, in the embodiment shown in FIG.17, when the pump module 34 is switched from OFF to ON for example, the control signal outputted from the comparator 20 is supplied to the drive circuit 34a via the low-pass filter 34d to drive the pump light source 34b. Therefore, the frequency component higher than the control band would never be included in the output pump light. Further, as the frequency band of the drive current is restricted, the transient response in spike would never be caused. Accordingly, the gain may be controlled to be constant by the pump module 33 which is already connected to the feedback loop and the pump module 34 which became newly operable. As it is structured in a manner that the low-pass filter is separated from the pump module 34 after a predetermined time period when the control system assumes a steady state, it becomes possible to enable both modules to equally operate for control in a given band. Moreover, as the low pass-filter is separated only when the steady state is established, the control system would never be disturbed to the extent where control is impossible. As stated in the foregoing, a new pump module may be incorporated in the gain control system in operation without even slightly varying the gain of the optical amplifier, construction of an optical amplifier in the cold standby becomes possible to thereby enhance the reliability greatly.

FIG. 18 shows the eighteenth embodiment of this invention wherein plural optical amplifiers 36 and 37 are connected in cascade, and when any of the amplifiers fails to achieve the reference gain, the gain distribution between the optical amplifiers 36 and 37 are controlled by a monitor and control unit 38 so as to make the net gain become constant. The optical amplifiers 36 and 37 may be any one of the embodiments stated above. With such a structure, when a required gain is not secured even if the pump light sources of the optical amplifier 37 of the latter stage is controlled, the pump light source of the optical amplifier 36 in the former stage is controlled to increase the gain to thereby make the net gain become constant. This optical amplifier can restore the system from a failure even when the number of available pump light sources is limited to thereby greatly enhance the reliability.

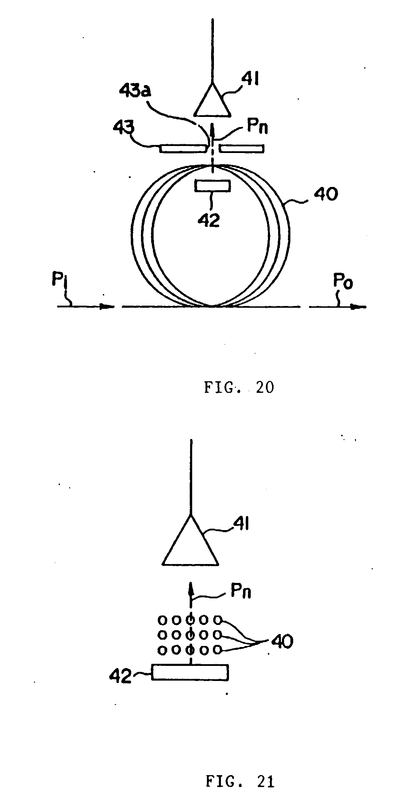

Experiments were conducted in order to evaluate this invention by using an amplifier as structured in Figures 20 and 21. An optical fiber 40 doped with erbium (Er) as a rare-earth atom is wound in a coil of a diameter of 100 mm. The optical fiber 40 were applied with UV coating so as to be able to detect the spontaneous emission from the sides thereof. The length of the optical fiber 40 was set at 25 m, and the erbium doping level of 1000 ppm. In order to detect spontaneous emission, a photodetector of diameter of 4 mm and a mirror 42 were placed at opposing positions cross a part of the coil of the optical fiber 40 and the spontaneous emission was detected through a slit 43a of a light blocking plate 43. The spontaneous emission from the coiled optical fiber 40 was sampled at an interval of about 310 mm. A 1.48 μm laser diode (not shown) was used to pump the optical fiber 40.

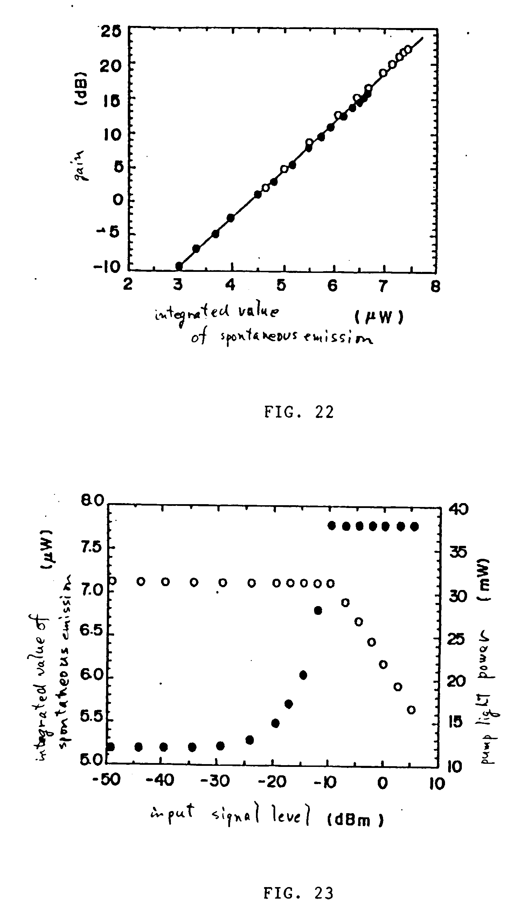

FIG. 22 shows the basic data to confirm the validity of the equation (3) on which was based the present invention. The graph shows the relation between gains of an optical amplifier and integrated spontaneous emission at various input signal powers. In the graph, the open circles denote the values obtained at the input signal power of -23.8 dBm and the solid circles denote those at -9.2 dBm. The graph clearly indicates that spontaneous emission is superior as a means for measuring the gain, and that this invention method works effectively as a means for integrating spontaneous emission.

FIG. 23 is a graph to show the relation between integrated spontaneous emission and the input signal power (open circles), and the relation between the pump light power and input signal power of the optical amplifier (solid circles) when the gains are controlled to be constant.

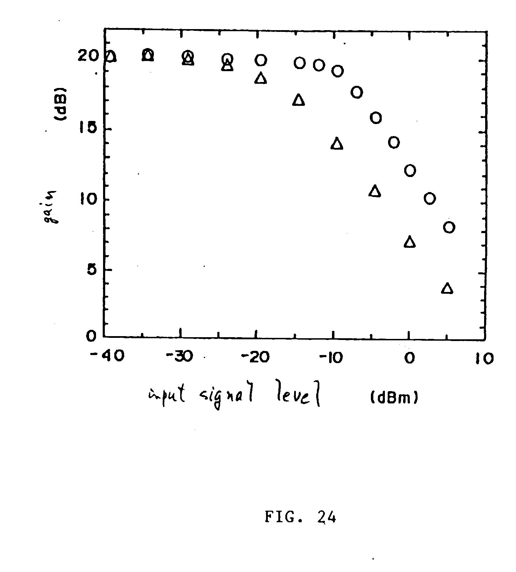

FIG. 24 is a graph to show the relation between the gain and the input signal power of an amplifier when the gain is controlled to be constant (AGC ON) (expressed by open circles in the graph) and when the gain is not controlled to be constant (AGC OFF) (by open triangles). The integrated spontaneous emission can be maintained constant by feedback to the pump light power up to the point when the input signal power becomes -10 dBm. In the meanwhile, the pump light power increased from 12 mW (input is -50 dBm) to 38 mW (input is -10 dBm). As the power of the pump light is limited to be 38 mW at maximum, the integrated spontaneous emission decreases from the point when the signal light exceeds -10 dBm.

The 1 dB gain compression input signal power for the 20 dB gain EDFA is-22 dBm without AGC, and -9 dBm with AGC. Therefore, it is indicated that the scope of the linear operation of the optical amplifier may be increased by about 13 dB by switching the AGC ON.

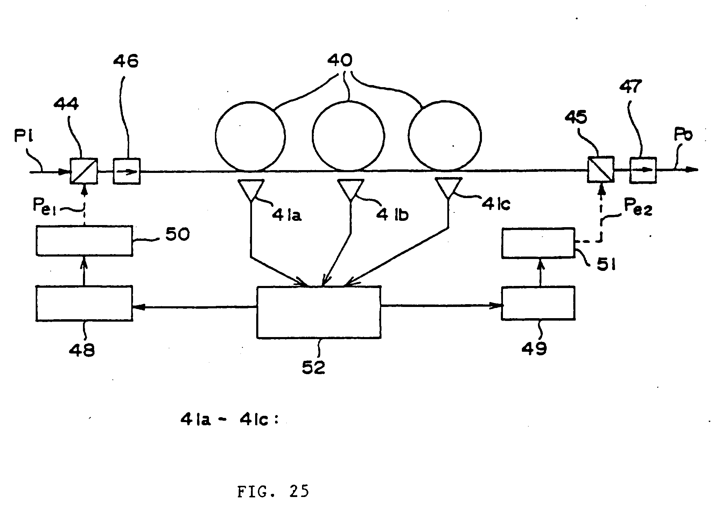

FIG. 25 shows another embodiment of this invention wherein the reference numeral 40 denotes rare-earth doped optical fiber, 41a, 41b and 41c photodetectors, 44 and 45 couplers, 46 and 47 isolators, 48 and 49 drive circuits, 50 and 51 pump light sources, and 52 a control unit. The photodetectors 41a, 41b and 41c are placed at different positions on the side of the rare-earth doped optical fiber 40 to detect spontaneous emission therefrom. A control unit 52 calculates these detected values based on the equations (3) and (4) to obtain the gain and noise figure NF and controls via the drive circuits 48 and 49 the pump light sources 50 and 51 which supply pumping lights respectively to the signal input side and the output side of the optical fiber 40 so as to minimize the noise figure NF at the constant gain. Even when either one of the light sources 50 and 51 fails, it can be controlled for the gain to become constant with the other light source, signals would not be suspended even for an instant to thereby enhance the reliability of the optical amplifier.

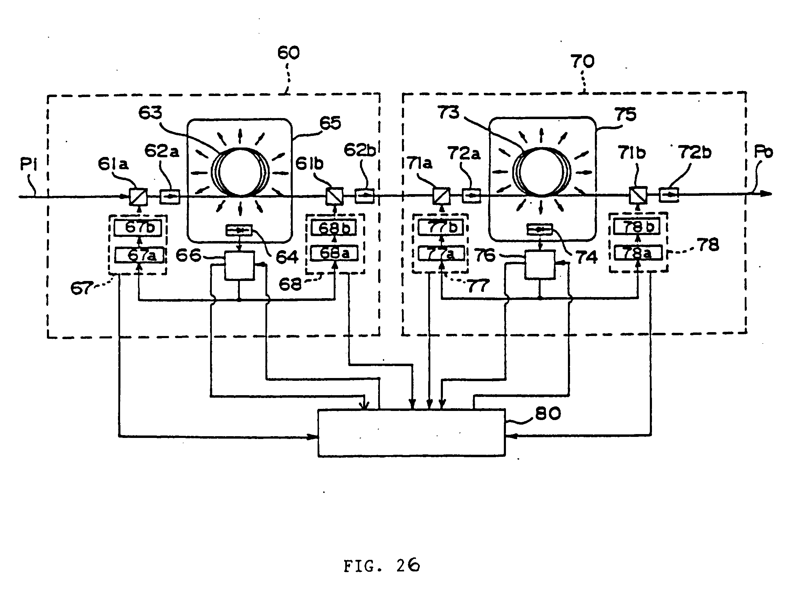

FIG. 26 shows still another embodiment of this invention wherein the reference numerals 60 and 70 denote optical amplifiers structured in two stages. A monitor and control unit 80 is provided for changing the gain distribution between the two optical amplifiers. Both of the optical amplifiers 60 and 70 are structured with rare-earth doped optical fiber amplifiers. The optical amplifier 60 comprises couplers 61a and 61b, isolators 62a and 62b, a rare-earth doped optical fiber 63, a photodetector 64, an integrating sphere 65, a comparator 66, a pump module 67 integrating a drive circuit 67a and a pump light source 67b, and a pump module 68 integrating a drive circuit 68a and a pump light source 68b. The optical amplifier 70 comprises couplers 71a and 71b, isolators 72a and 72b, a rare-earth doped optical fiber 73, a photodetector 74, an integrating sphere 75, a comparator 76, a pump module 77 integrating a drive circuit 77a and a pump light source 77b, and a pump module 78 integrating a drive circuit 78a and a pump light source 78b. Because of such a structure, even if a part of the pump light sources fails, AGC may be conducted using the rest of the light sources to maintain the operation of the optical amplifier without a change in the gain. When the pump light power from the rest of the light sources is not enough, the gain may decrease, but the state of the pump light sources of the two stages is monitored by the monitor and control unit 80 so as to set the gain of the amplifier still having a margin in the power at a higher level and to set the gain of the amplifier not having enough power at a lower level. As a result, the net gain of the system may be controlled to become constant. The gain of the amplifier can be protected multiply to prevent optical signals from being suspended even for an instant to thereby greatly enhance the reliability of the optical amplifier.

## Claims

1. An optical amplifier comprising a rare-earth doped optical fibre (4), a pump light source (8) for pumping light into the optical fibre (4) to excite the rare-earth dopant which, in operation, amplifies an optical signal incident on the optical fibre (4), characterised in that the optical amplifier includes a detecting means (5) for detecting spontaneous emission from the sides of the optical fibre (4) and a feedback means for so controlling the pump light source (8) that, in operation, the detected level of the spontaneous emission is maintained substantially constant.

2. An optical amplifier as claimed in claim 1, wherein the detecting means (5) includes a photodetector and the photodetector is placed within an integrating sphere (6) that surrounds the optical fibre (4).

3. An optical amplifier as claimed in claim 1, wherein the optical fibre (4) forms a coil and the detecting means (5) includes a photodetector positioned by the side of the coil.

4. An optical amplifier as claimed in claim 1, wherein the optical fibre (4) includes a series of loops forming a curved structure having convex and concave faces and the detecting means (5) includes a photodetector positioned to receive light from the concave face of the curved structure.

5. An optical amplifier as claimed in any one of claims 1 to 4, wherein the detecting means (5) includes a plurality of photodetectors positioned along the optical fibre (4), the feedback means including a processing means (9) for processing the detected values obtained from the plurality of photodetectors and controlling the pump light source (8) in accordance with the processed values.

6. An optical amplifier as claimed in any one of claims 1 to 5, including an optical bandpass filter (10), the detecting means (5) including a photodetector and the optical bandpass filter (10) being positioned between the photodetector and the optical fibre (4) for selecting light close to the signal-light wavelength for transmission to the photodetector.

7. An optical amplifier as claimed in any one of claims 1 to 6, including a mirror (11) so positioned that the optical fibre (4) lies between the mirror (11) and the detecting means (5).

8. An optical amplifier as claimed in any one of claims 1 to 7, including an optical system (13) positioned between the detecting means (5) and the optical fibre (4), the optical system (13) being capable of compensating for variations in the sensitivity of the detecting means (5) according to the angle at which light falls on the detecting means (5).

9. An optical amplifier as claimed in any one of claims 1 to 8, including a second detecting means (18) for detecting the optical power output from the optical fibre (4) at the signal-wavelength, an integrating means (19) for integrating the detected optical power over a period longer than a time constant $T_s$ based on the statistical characteristics of the signal and a control means (20,7) for so controlling the reference gain of the doped optical fibre (4) in accordance with the output value from the integrating means (19) as to cause the average optical power output from the optical fibre (4) to remain substantially constant.

10. An optical amplifier as claimed in any one of claims 1 to 9, including a first computing means (9) for receiving information from the feedback means regarding the power supplied by the pump light source (8) and calculating the optical power output from the optical fibre (4) in accordance with the relationship between a previous pump light power and the corresponding gain of the optical fibre (4), a second computing means (19) for integrating the calculated value of the optical power output over a period longer than a time constant $T_s$ based on the statistical characteristics of the signals in order to obtain an average value of the optical power output and a control means (20) for so controlling the feedback means as to make the average value of the optical power output equal to a selected reference value.

11. An optical amplifier as claimed in any one of claims 1 to 10, including a control unit (16,7) connected to control the pump light source (8), the control unit (16,7) including an input port for receiving the output from the detecting means (5), input ports for receiving setting values for gain and wavelength for the optical fibre (4) and an output port for providing an alarm signal when the control unit (16,7) so controls the pump light source (8) as to demand output power at a level that exceeds an operational limit that is determined by the set values for gain and wavelength.

12. An optical amplifier as claimed in any one of claims 1 to 11, including a temperature sensor (22) positioned to sense the temperature of the optical fibre (4), the temperature sensor (22) being connected to a compensating means (23,24) for so varying the power delivered by the pump light source (8) as to compensate for temperature-dependent changes in the spontaneous emissions from the optical fibre (4).

13. An optical amplifier as claimed in any one of claims 1 to 12, including an additional pump light source (28) for pumping light into the optical fibre (4) connected to an additional detecting means (25) for detecting spontaneous emissions from the sides of the optical fibre (4) and an additional feedback means for controlling the output power from the additional pump light source (28), the gains of the feedback means being set to differ from each other.

14. An optical amplifier as claimed in claim 13, including a monitor-and-control unit (30) for monitoring the operation of each of the feedback means, setting the gain of each of the feedback means and switching off any faulty feedback means.

15. An optical amplifier as claimed in claim 13 or 14, wherein the feedback means include drive circuits (31a,32a) for offsetting differences in characteristics between the pump light sources (31b,32b).

16. An optical amplifier as claimed in claim 15, wherein each pump light source (31b,32b) is an integral part of a pump module (31,32) that includes a drive circuit (31a,32a) for the pump light source (31b,32b).

17. An optical amplifier as claimed in claim 16, wherein the pump modules (31,32) are capable of being switched on and off and means are included for switching the pump modules (31,32) on and off, the optical amplifier including low-pass electrical filters (33c,34c) for the feedback means that control the respective pump modules (31,32) and a comparator means (35) for inserting the low-pass electrical filters (33c,34c) into the respective feedback means for a predetermined period that starts when the respective pump modules (31,32) are switched on, the low-pass electrical filters (33c,34c) having narrower passbands than the respective feedback means.

18. An optical amplifier as claimed in any one of claims 1 to 17 connected in cascade with a similar amplifier, wherein the gain of the first amplifier in the cascade is greater than that of the second amplifier in the cascade.

19. An optical amplifier as claimed in any one of claims 1 to 17 connected in cascade with a plurality of similar amplifiers and including a multiple-control monitor-and-control unit (80) for so varying the gain distribution among the amplifiers as to maintain a constant gain for the cascade of amplifiers.

**Patentansprüche**

1. Ein optischer Verstärker, umfassend eine mit seltener Erde dotierte optische Faser (4), eine Pumplichtquelle (8) für das Pumpen von Licht in die optische Faser (4) zum Anregen des Dotierungsmittels aus seltener Erde, welches im Betrieb ein auf die optische Faser (4) auftreffendes optisches Signal verstärkt, dadurch gekennzeichnet, daß der optische Verstärker ein Erfassungsmittel (5) für das Erfassen spontaner Emission von den Seiten der optischen Faser (4) sowie ein Rückkopplungsmittel umfaßt, um die Pumplichtquelle (8) derart zu steuern, daß im Betrieb der erfaßte Pegel der Spontanemission im wesentlichen konstant gehalten wird.

2. Ein optischer Verstärker nach Anspruch 1, bei dem das Erfassungsmittel (5) einen Photodetektor umfaßt und der Photodetektor innerhalb einer integrierenden Kugel (6) plaziert ist, welche die optische Faser (4) umschließt.

3. Ein optischer Verstärker nach Anspruch 1, bei dem die optische Faser (4) eine Spule bildet und das Erfassungsmittel (5) einen seitlich der Spule positionierten Photodetektor umfaßt.

4. Ein optischer Verstärker nach Anspruch 1, bei dem die optische Faser (4) eine Serie von Schlaufen umfaßt, die eine gekrümmte Struktur mit konvexen und konkaven Seiten bilden, und bei dem das Erfassungsmittel (5) einen Photodetektor umfaßt, der für den Empfang von Licht von der konkaven Seite der gekrümmten Struktur positioniert ist.

5. Ein optischer Verstärker nach einem der Ansprüche 1 bis 4, bei dem das Erfassungsmittel (5) eine Mehrzahl von Photodetektoren umfaßt, die längs der optischen Faser (4) positioniert sind, wobei das Rückkopplungsmittel ein Verarbeitungsmittel (9) für das Verarbeiten der erfaßten Werte, erhalten von der Mehrzahl von Photodetektoren, umfaßt und die Pumplichtquelle (8) gemäß den verarbeiteten Werten steuert.

6. Ein optischer Verstärker nach einem der Ansprüche 1 bis 5 einschließlich eines optischen Bandpaßfilters (10), wobei das Erfassungsmittel (5) einen Photodetektor umfaßt und das optische Bandpaßfilter (10) zwischen dem Photodetektor und der optischen Faser (4) für das Auswählen von Licht nahe der Signallichtwellenlänge für Übertragung zu dem Photodetektor positioniert ist.

7. Ein optischer Verstärker nach einem der Ansprüche 1 bis 6 einschließlich eines Spiegels (11), der derart positioniert ist, daß die optische Faser (4) zwischen dem Spiegel (11) und dem Erfassungsmittel (5) liegt.

8. Ein optischer Verstärker nach einem der Ansprüche 1 bis 7 einschließlich eines optischen Systems (13), das zwischen dem Erfassungsmittel (5) und der optischen Faser (4) positioniert ist, welches optische System (13) für die Kompensation von Variationen in der Empfindlichkeit des Erfassungsmittels (5) entsprechend dem Winkel ausgebildet ist, unter dem Licht auf das Erfassungsmittel (5) fällt.

9. Ein optischer Verstärker nach einem der Ansprüche 1 bis 8 einschließlich eines zweiten Erfassungsmittels (18) für das Erfassen der optischen Ausgangsleistung von der optischen Faser (4) bei der Signalwellenlänge, mit einem Integrationsmittel (19) für das Integrieren der erfaßten optischen Leistung über eine Periode, die länger ist als eine Zeitkonstante $T_S$ basierend auf den statistischen Charakteristiken des Signals, und mit einem Steuermittel (20,7) für die Steuerung des Referenzverstärkungsfaktors der dotierten optischen Faser (4) entsprechend dem Ausgangswert von dem Integrationsmittel (19), um zu bewirken, daß die mittlere optische Ausgangsleistung von der optischen Faser (4) im wesentlichen konstant bleibt.

10. Ein optischer Verstärker nach einem der Ansprüche 1 bis 9 mit einem ersten Berechnungsmittel (9) für den Empfang von Information von dem Rückkopplungsmittel bezüglich der von der Pumplichtquelle (8) zugeführten Leistung und Berechnen der optischen Ausgangsleistung aus der optischen Faser (4) entsprechend der Beziehung zwischen einer vorherigen Pumplichtleistung und der entsprechenden Verstärkung der optischen Faser (4), mit einem zweiten Berechnungsmittel (19) für das Integrieren des berechneten Wertes der optischen Ausgangsleistung über eine Periode, die länger ist als eine Zeitkonstante $T_S$ basierend auf den statistischen Charakteristiken der Signale, um einen Mittelwert der optischen Ausgangsleistung zu gewinnen, und mit einem Steuermittel (20) für die Steuerung des Rückkopplungsmittels derart, daß der Mittelwert der optischen Ausgangsleistung gleich einem ausgewählten Referenzwert gemacht wird.

11. Ein optischer Verstärker nach einem der Ansprüche 1 bis 10 mit einer Steuereinheit (16,7), die zur Steuerung der Pumplichtquelle (8) angeschlossen ist, welche Steuereinheit (16,7) einen Eingang für den Empfang des Ausgangs von dem Erfassungsmittel (5), Eingänge für den Empfang von Einstellwerten für die Verstärkung und die Wellenlänge für die optische Faser (4) und einen Ausgang für das Bereitstellen eines Alarmsignals umfaßt, wenn die Steuereinheit (16,7) die Pumplichtquelle (8) so steuert, daß Ausgangsleistung bei einem Pegel gefordert wird, welcher eine Betriebsgrenze übersteigt, die durch die gesetzten Werte für Verstärkung und Wellenlänge bestimmt ist.

**12.** Ein optischer Verstärker nach einem der Ansprüche 1 bis 11 mit einem Temperatursensor (22), positioniert zum Erfassen der Temperatur der optischen Faser (4), welcher Temperatursensor (22) mit einem Kompensationsmittel (23,24) verbunden ist, um die von der Pumplichtquelle (8) abgegebene Leistung so zu variieren, daß temperaturabhängige Änderungen in den spontanen Emissionen von der optischen Faser (4) kompensiert werden.

**13.** Ein optischer Verstärker nach einem der Ansprüche 1 bis 12 mit einer zusätzlichen Pumplichtquelle (28) für das Pumpen von Licht in die optische Faser (4), verbunden mit einem zusätzlichen Erfassungsmittel (25) für das Erfassen spontaner Emissionen von den Seiten der optischen Faser (4), und mit einem zusätzlichen Rückkopplungsmittel für die Steuerung der Ausgangsleistung von der zusätzlichen Pumplichtquelle (28), wobei die Verstärkungsfaktoren der Rückkopplungsmittel so eingestellt sind, daß sie zueinander verschieden sind.

**14.** Ein optischer Verstärker nach Anspruch 13 einschließlich einer überwachungs- und Steuereinheit (30) für die Überwachung des Betriebs jedes der Rückkopplungsmittel, Einstellen der Verstärkung jedes der Rückkopplungsmittel und Ausschalten irgendeines fehlerhaften Rückkopplungsmittels.

**15.** Ein optischer Verstärker nach Anspruch 13 oder 14, bei dem das Rückkopplungsmittel Treiberschaltungen (31a, 32a) für das Ausgleichen von Differenzen in den Charakteristiken zwischen den Pumplichtquellen (31b, 32b) umfaßt.

**16.** Ein optischer Verstärker nach Anspruch 15, bei dem jede Pumplichtquelle (31b,32b) ein integraler Teil eines Pumpmoduls (31,32) ist, der eine Treiberschaltung (31a,32a) für die Pumplichtquelle (31b,32b) umfaßt.

**17.** Ein optischer Verstärker nach Anspruch 16, bei dem die Pumpmodule (31,32) ausgebildet sind, um ein- und ausgeschaltet zu werden, und Mittel vorgesehen sind für das Ein- und Ausschalten der Pumpmodule (31,32), welcher optische Verstärker elektrische Tiefpaßfilter (33c,34c) für das Rückkopplungsmittel umfaßt, das die entsprechenden Pumpmodule (31,32) steuert, und ein Komparatormittel (35) umfaßt für das Einfügen der elektrischen Tiefpaßfilter (33c,34c) in das entsprechende Rückkopplungsmittel während einer vorbestimmten Periode, die beginnt, wenn die entsprechenden Pumpmodule (31,32) eingeschaltet werden, welche elektrischen Tiefpaßfilter (33c,34c) schmalere Durchlaßbänder als die entsprechenden Rückkopplungsmittel haben.

**18.** Ein optischer Verstärker nach einem der Ansprüche 1 bis 17 in Kaskade mit einem ähnlichen Verstärker geschaltet, wobei die Verstärkung des ersten Verstärkers in der Kaskade größer ist als jene des zweiten Verstärkers in der Kaskade.

**19.** Ein optischer Verstärker nach einem der Ansprüche 1 bis 17 in Kaskade mit einer Mehrzahl ähnlicher Verstärker geschaltet und mit einer Mehrfachsteuerungsüberwachungs- und -steuereinheit (80) für die Veränderung der Verstärkungsverteilung unter den Verstärkern derart, daß eine konstante Verstärkung für die Kaskade von Verstärkern aufrechterhalten wird.


**Revendications**

**1.** Amplificateur optique, comprenant une fibre optique (4) dopée avec une terre rare, une source (8) de lumière de pompage servant à pomper de la lumière dans la fibre optique (4) de façon à exciter le dopant en terre rare qui, en cours de fonctionnement, amplifie les signaux optiques incidents sur la fibre optique (4), caractérisé en ce que l'amplificateur optique inclut des moyens de détection (5) servant à détecter les émissions spontanées provenant des parois de la fibre optique (4), et des moyens de rétroaction servant à contrôler la source (8) de lumière de pompage de telle sorte que, en cours de fonctionnement, le niveau d'émission spontanée détecté soit maintenu approximativement constant.

**2.** Amplificateur optique selon la revendication 1, dans lequel les moyens de détection (5) incluent un photodétecteur, et le photodétecteur est placé à l'intérieur d'une sphère d'intégration (6) entourant la fibre optique (4).

**3.** Amplificateur optique selon la revendication 1, dans lequel la fibre optique (4) forme une boucle, et les moyens de détection (5) incluent un photodétecteur placé sur le côté de la boucle.

**4.** Amplificateur optique selon la revendication 1, dans lequel la fibre optique (4) inclut une série de boucles formant une structure incurvée possédant une face convexe et une face concave, et les moyens de détection (5) incluent un photodétecteur placé de manière à recevoir la lumière en provenance de la face concave de la structure incurvée.

**5.** Amplificatuer optique selon l'une quelconque des revendications 1 à 4, dans lequel les moyens de détection (5) incluent un certain nombre de photodétecteurs placés le long de la fibre optique (4), les moyens de rétroaction incluant des moyens de traitement (9) servant à traiter les valeurs détectées fournies par les multiples photodétecteurs, et à contrôler la source (8) de lumière de pompage en fonction des valeurs traitées.

**6.** Amplificateur optique selon l'une quelconque des revendications 1 à 5, incluant un filtre optique passe-bande (10), les moyens de détection (5) incluant un photodétecteur, et le filtre optique passe-bande (10) étant placé entre le photodétecteur et la fibre optique (4) afin de sélectionner la lumière proche de la longueur d'onde du signal lumineux, aux fins de transmission au photodétecteur.

**7.** Amplificateur optique selon l'une quelconque des revendications 1 à 6, incluant un miroir (11) placé de telle sorte que la fibre optique (4) se trouve entre le miroir (11) et les moyens de détection (5).

**8.** Amplificateur optique selon l'une quelconque des revendications 1 à 7, incluant un système optique (13) placé entre les moyens de détection (5) et la fibre optique (4), le système optique (13) étant capable de compenser les variations de sensibilité des moyens de détection (5) en fonction de l'angle auquel la lumière tombe sur les moyens de détection (5).

**9.** Amplificateur optique selon l'une quelconque des revendications 1 à 8, incluant des moyens de détection supplémentaires (18) servant à détecter la puissance optique produite par la fibre optique (4) à la longueur d'onde du signal, des moyens d'intégration (19) servant à intégrer la puissance optique détectée, sur une durée plus longue qu'une constant de temps $T_S$ déterminée d'après les caractéristiques statistiques du signal, et des moyens de contrôle (20.7) servant à contrôler le gain de référence de la fibre optique dopée (4), d'après la valeur fournie par les moyens d'intégration (19), de telle sorte que la puissance optique moyenne produite par la fibre optique (4) demeure approximativement constante.

**10.** Amplificateur optique selon l'une quelconque des revendications 1 à 9, incluant des premiers moyens de calcul (9) servant à recevoir des informations de la part des moyens de rétroaction concernant la puissance émise par la source (8) de lumière de pompage et à calculer la puissance optique produite par la fibre optique (4), d'après la relation entre la puissance d'une lumière de pompage antérieure et le gain correspondant de la fibre optique (4), des seconds moyens de calcul (19) servant à intégrer la valeur calculée de la puissance optique produite, sur une durée plus longue qu'une constante de temps $T_S$ déterminée d'après les caractéristiques statistiques des signaux, afin d'obtenir une valeur moyenne de la puissance optique produite, et des moyens de contrôle (20) servant à contrôler les moyens de rétroaction de telle sorte que la valeur moyenne de la puissance optique produite soit égale à une valeur de référence choisie.

**11.** Amplificateur optique selon l'une quelconque des revendications 1 à 10, incluant une unité de contrôle (16,7) reliée de façon à contrôler la source (8) de lumière de pompage, cette unité de contrôle (16,7) incluant un port d'entrée servant à recevoir le signal sortant des moyens de détection (5), des ports d'entrée servant à recevoir des valeurs de réglage pour le gain et la longueur d'onde de la fibre optique (4), et un port de sortie servant à émettre un signal d'alarme quand l'unité de contrôle (16,7) qui contrôle la source (8) de lumière de pompage réclame une puissance de sortie d'un niveau excédant une limite de fonctionnement déterminée d'après les valeurs fixées pour le gain et la longueur d'onde.

**12.** Amplificateur optique selon l'une quelconque des revendications 1 à 11, incluant un détecteur de température (22) placé de façon à mesurer la température de la fibre optique (4), ce détecteur de température (22) étant relié à des moyens de compensation (23,24) servant à faire varier la puissance produite par la source (8) de lumière de pompage, de manière à compenser les changements intervenant dans les émissions spontanées de la part de la fibre optique (4) et qui sont fonction de la température.

**13.** Amplificateur optique selon l'une quelconque des revendications 1 à 12, incluant une source supplémentaire (28) de lumière de pompage servant à pomper de la lumière dans la fibre optique (4), reliée à des moyens de détection supplémentaires (25) servant à détecter les émissions spontanées provenant des parois de la fibre optique (4), et des moyens de rétroaction supplémentaires servant à contrôler la puissance produite par la source supplémentaire (28) de lumière de pompage, les gains des moyens de rétroaction respectifs étant réglés à des valeurs différentes l'une de l'autre.

14. Amplificateur optique selon la revendication 13, incluant une unité (30) de surveillance-et-contrôle servant à surveiller le fonctionnement des moyens de rétroactions respectifs, à régler les gains respectifs des moyens de rétroaction, et à éteindre tous moyens de rétroaction qui tomberaient en panne.

15. Amplificateur optique selon la revendication 13 ou 14, dans lequel les moyens de rétroaction incluent des circuits pilotes (31a,32a) servant à annuler les différences entre les propriétés des sources (31b,32b) de lumière de pompage.

16. Amplificateur optique selon la revendication 15, dans lequel chaque source (31b,32b) de lumière de pompage fait intégralement partie d'un module de pompage (31,32) qui inclut un circuit pilote (31a,32a) pour la source (31b, 32b) de lumière de pompage.

17. Amplificateur optique selon la revendication 16, dans lequel les modules de pompage (31,32) peuvent être allumés ou éteints, et l'on a inclus des moyens pour allumer ou éteindre les modules de pompage (31,32), l'amplificateur optique incluant des filtres électriques passe-bas (33c,34c) pour les moyens de rétroaction qui contrôlent les modules de pompage respectifs (31,32), et des moyens comparateurs (35) servant à insérer les filtres électriques passe-bas (33c,34c) dans les moyens de rétroaction respectifs, pendant une durée prédéterminée qui débute quand les modules de pompage respectifs (31,32) sont allumés, les filtres électriques passe-bas (33c,34c) ayant des bandes passantes plus étroites que les moyens de rétroaction respectifs.

18. Amplificateur optique selon l'une quelconque des revendications 1 à 17, relié en cascade à un amplificateur similaire, où le gain du premier amplificateur de la cascade est supérieur à celui du second amplificateur de la cascade.

19. Amplificateur optique selon l'une quelconque des revendications 1 à 17, relié en cascade à un certain nombre d'amplificateurs similaires, et incluant une unité de surveillance-et-contrôle à contrôle-multiple (80) servant à faire varier les valeurs de gain entre les amplificateurs de telle sorte que la cascade d'amplificateurs maintienne un gain constant.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

FIG. 18

FIG. 19

FIG. 20

FIG. 21

FIG. 22

FIG. 23

FIG. 24

FIG. 25

FIG. 26